# EUROPÄISCHE PATENTANMELDUNG

(11) **EP 2 261 618 A1**
(43) Veröffentlichungstag der Anmeldung: **15.12.2010**
(21) Anmeldenummer: 09007538.3
(22) Anmeldetag: 08.06.2009
(51) Int. Cl.: G01J 3/10, H05B 3/26

(54) **Miniatur-Infrarotlichtquelle**

(71) Anmelder: Leister Process Technologies, 6056 Kägiswil (CH)
(72) Erfinder: Dubochet, oliver, 6056 Kägiswil (CH); Krebs, Stefan, 6055 Alpnach (CH); Hessler, Thomas, 6072 Sachseln (CH)
(74) Vertreter: Klocke, Peter

(57) **Zusammenfassung**

Die Erfindung betrifft eine Miniatur-Infrarotlichtquelle (1) vorzugsweise hoher Leistung für einen Gassensor, mit einem Hitze beständigen, Licht undurchlässigen oder Licht durchlässigen Gehäuse (2), das eine Bodenplatte (3) und der Bodenplatte (3) gegenüber liegend eine Austrittsöffnung (5) oder ein Austrittsfenster für IR-Strahlung aufweist, die von einem in dem Gehäuse (2) an der Bodenplatte (3) angeordneten, als dünne Membran ausgebildeten Silizium-Chip (4) beim Durchleiten eines geeigneten Heizstroms ausgeht, wobei der Silizium-Chip (4) mittels voneinander isolierten, das Gehäuse (2) dichtend durchtretenden elektrischen Anschlussleitungen (6) bestrombar ist. Die Erfindung sieht vor, das Gehäuse (2) und die Anschlussleitungen (6) nach Art eines Oberflächen montierbaren Bauelements auszubilden. Die Erfindung betrifft außerdem eine Detektoranordnung, umfassend mindestens eine erfindungsgemäße Miniatur-Infrarotlichtquelle (1) und einen zugeordneten Infrarotdetektor (19).

## Beschreibung

Die Erfindung betrifft eine Miniatur-Infrarotlichtquelle mit einem Hitze beständigen, Licht undurchlässigen oder Licht durchlässigen Gehäuse, das eine Bodenplatte und der Bodenplatte gegenüber liegend eine Austrittsöffnung oder ein Austrittsfenster für IR-Strahlung aufweist, die von einem in dem Gehäuse an der Bodenplatte angeordneten, mindestens eine dünne Siliziummembran aufweisenden Silizium-Chip als IR-Quelle beim Durchleiten eines geeigneten Heizstroms ausgeht, wobei der Silizium-Chip mittels voneinander isolierten, das Gehäuse dichtend durchtretenden elektrischen Anschlussleitungen bestrombar ist. Die Erfindung betrifft außerdem eine Detektoranordnung für einen Gassensor, mit einer Miniatur-Infrarotlichtquelle und einem Infrarotdetektor.

Infrarotlichtquellen sind in vielfältigen Ausführungsformen bekannt und werden für die unterschiedlichsten Anwendungen hergestellt und eingesetzt. In Abhängigkeit von dem zur Emission der IR-Strahlung verwendeten Material und der Anregungsart strahlen derartige IR-Quellen Infrarotlicht unterschiedlicher Wellenlänge ab. Es ist beispielsweise bekannt, Miniatur-Infrarotlichtquellen hoher Leistung für einen Gassensor auf der Basis von dünnschichtigen Silizium-Chips herzustellen.

Bei derartigen Dünnschicht-Infrarotlichtquellen wird eine dünne Membran eines Silizium-Chips durch Joule'sche Wärme auf Temperaturen von 400 bis 600 °C erhitzt und diese damit zur Emission von IR-Strahlung angeregt. Die Auslegung als Dünnschichtmembran erlaubt dabei schnelle Aufheiz- und Abkühlzeiten, vor allem gegenüber den herkömmlichen IR-Quellen auf Glühwendelbasis. Bisher werden die dafür verwendeten Silizium-Chips in ein standardisiertes TO-Gehäuse eingesetzt. Dieses Gehäuse kann entweder mit Standardkappen oder mit entsprechend angepassten Reflektoren versehen werden. Die so erstellte IR-Lichtquelle wird bisher als Komponente in Geräten, meist Gassensoren verbaut, wobei für den elektrischen Anschluss drahtförmige Anschlusspins aus dem Gehäuse der IR-Lichtquelle heraus führen. Das Verlöten der Pins geschieht dabei in der Regel per Hand und verursacht daher relativ hohe Herstellkosten. Die Ausführung des TO-Gehäuses macht ein Verarbeiten mit heute industrieüblichen Lötanlagen nicht möglich.

Ausgehend von dem vorstehend dargestellten Stand der Technik liegt der Erfindung die Aufgabe zu Grunde eine Möglichkeit vorzuschlagen, die eine automatische Bestückung und einen anschließenden automatisierten Lötprozess für die Miniatur-Infrarotlichtquelle ermöglicht. Der Erfindung liegt außerdem die Aufgabe zu Grunde, eine zur automatischen Verarbeitung geeignete Detektoranordnung vorzuschlagen.

Diese Aufgabe wird erfindungsgemäß durch eine Miniatur-Infrarotlichtquelle mit den Merkmalen des Anspruchs 1 sowie durch eine Detektoranordnung mit den Merkmalen des nebengeordneten Anspruchs 9 gelöst. Weitere vorteilhafte Ausgestaltungen sind den jeweiligen rückbezogenen Ansprüchen zu entnehmen.

Der Erfindung liegt die Idee zu Grunde, die Miniatur-Infrarotlichtquelle als Surface Mounted Device (SMD) auszuführen.

Erfindungsgemäß sind das Gehäuse und die Anschlussleitungen der vorgeschlagenen Miniatur-Infrarotlichtquelle nach Art eines Oberfächen montierbaren Bauelements ausgebildet. Der Begriff Surface Mounted Device ist ein Fachbegriff aus der Elektronik und bezeichnet ein Oberflächen montierbares Bauteil. Derartige Bauelemente wie zum Beispiel Widerstände, Kondensatoren, Quarze, Dioden, Transistoren oder integrierte Schaltungen haben im Gegensatz zu den Bauelementen der Durchsteckmontage (Through Hole Technology, THT), den "bedrahteten Bauelementen", keine Drahtanschlüsse, sondern werden mittels lötfähiger Anschlussflächen direkt auf eine Leiterplatte (Flachbaugruppe) gelötet. Die dazu gehörige Technik ist als Oberflächenmontagetechnik (Surface-Mounting-Technology, SMT) bekannt. Die Ausbildung der erfindungsgemäßen Miniatur-Infrarotlichtquelle als Oberflächen montierbares Bauelement und dessen Verarbeitung gemäß der Oberflächenmontagetechnik bringt eine Vielzahl von Vorteilen mit sich.

Als Vorteile sind bekannt:
- Miniaturisierung, deutliche Verkleinerung von Schaltungen und Geräten durch kleinere Bauteilabmessungen, höhere Bauteildichte, kleinere Leiterplatten mit engerem Leiterbahnabstand und dünneren Leiterbahnen;
- Kostenreduzierung, da die Bohrungen in der Leiterplatte entfallen;
- schnellere Gerätefertigung durch schnelle Automatenbestückung und damit verbunden geringere Fertigungskosten;
- Gewichtsreduzierung durch Wegfall von Anschlussdrähten und kleinere Bauformen;
- Verbesserung von HF-Eigenschaften der SMD-Platine;
- Steigerung der Fertigungsqualität bei automatischer Bestückung;
- hohe Positioniergenauigkeit bei der Bauteilbestückung bzw. beim Lötprozess; und
- hohe Zuverlässigkeit der SMD-Platine.

Die erfindungsgemäße Miniatur-Infrarotlichtquelle ist vorzugsweise für empfindliche und zuverlässige IR-Gassensoren vorgesehen und weist dementsprechend eine hohe Leistung auf. Sie weist eine Infrarot-Emission bei den typischen Absorptionsbanden der zu detektierenden Gase auf und besteht im Wesentlichen aus einer dünnen, mikrotechnisch hergestellten Membran, auf der eine Widerstandsheizung aufgebracht ist. Dabei kann der Silizium-Chip eine oder mehrere nebeneinender angeordnete, elektrisch leitend miteinander verbundene Membranen aufweisen oder als einstückige Microbridge ausgeführt sein. Die geringe thermische Masse und den hohen Emissionsgrad der Heizfläche ermöglichen eine schnelle Modulation der thermischen IR-Strahlung durch eine einfache Variation der Versorgungsspannung. Auf mechanische Modulatoren kann somit weitgehend verzichtet werden.

Das Gehäuse der erfindungsgemäßen Miniatur-Infrarotlichtquelle ist ein vorgefertigtes, vorzugsweise quaderförmiges Kunststoffgehäuse mit einer Bodenplatte, das zumindest auf der der Bodenplatte gegenüber liegenden Gehäuseseite für Infrarotstrahlung durchgängig ist, und mit wenigstens zwei Anschlussleitungen in Form von Kontaktierungsstreifen, die in das Gehäuse eingebettet und in der Form ein- oder mehrfach abgewinkelt sind. Generell kann das Gehäuse ein Licht durchlässiges oder ein nicht Licht durchlässiges Material aufweisen. Mindestens Im Falle eines Licht undurchlässigen Gehäuses ist der Bodenplatte gegenüber liegend eine Austrittsöffnung oder ein transparentes Austrittsfenster für IR-Strahlung vorgesehen. Auf der Bodenplatte ist der als dünne Membran ausgebildete Silizium-Chip befestigt und elektrisch leitend mit den die Anschlussleitungen bildenden Kontaktierungsstreifen verbunden. Dabei kann der Silizium-Chip von einem Substrat getragen oder direkt mit der Bodenplatte verklebt sein. Vorzugsweise ist der Silizium-Chip ohne Substrat auf der Bodenplatte angeordnet.

Prinzipiell kann das Gehäuse der erfindungsgemäßen Miniatur-Infrarotlichtquelle eine beliebige Außenkontur und eine beliebige Innenkontur mit einer SMDtauglichen Form aufweisen. Als SMD-tauglich wird ein Gehäuse angesehen, das außenseitig mindestens eine ebene, der Leiterplatte zugeordnete Gehäuseseite als Befestigungsseite aufweist. Dabei kann es zweckmäßig sein, die Innenkontur des Gehäuses mit beliebigen, für eine gewisse Strahlformung und/oder Strahllenkung geeigneten Geometrien auszubilden.

An sich kann das Gehäuse beliebige Materialien aufweisen, wobei elektrisch isolierende Materialien bevorzugt werden. Damit können die elektrischen Anschlussleitungen ohne zusätzliche Isolierung in das Gehäuse geführt werden.

Abhängig von der Gehäusegröße und einer vorgesehenen liegenden oder stehenden Anordnung der Bodenplatte bezüglich der Leiterplatte können die Kontaktierungsstreifen, die vorzugsweise als Stanzblegeteile ausgeführt sind, das Gehäuse auf beliebigen geeigneten Gehäuseseiten durchsetzen. Je nach der Durchtrittsstelle sind dabei mehr oder weniger Abwinkelungen der Kontaktierungsstreifen notwendig, um die Leiterplatte zu erreichen.

Vorzugsweise ist der Silizium-Chip auf einer Wärmesenke der Bodenplatte angeordnet. Dabei kann einer der vorgesehenen Kontaktierungsstreifen oder ein zusätzliches Anschlusselement als Blindleitung die Wärmesenke bilden. Als Blindleitung wird in diesem Zusammenhang ein Anschlusselement verstanden, das nicht stromführend ist. Es kann wie die stromführenden Kontaktierungsstreifen abhängig von seiner Durchtrittsstelle am Gehäuse und seiner Querschnittsform keine, eine oder auch mehr als eine Abwinkelung aufweisen. Mit der Wärmesenke ist der Silizium-Chip gut Wärme leitend verbunden.

In allen möglichen Ausführungsformen des Gehäuses der beanspruchten Miniatur-Infrarotlichtquelle kann die der Bodenplatte gegenüber liegende, an sich vorzugsweise offene Gehäuseseite ein hermetisch abgedichtetes Austrittsfenster für die IR-Strahlung aufweisen. Dem Silizium-Chip gegenüber liegend ist an dem Austrittsfenster vorzugsweise ein Filter zur Selektion einer Wellenlänge angeordnet, wobei das Filter dem Austrittsfenster in Emissionsrichtung vor- oder nachgelagert sein kann oder das Austrittsfenster bilden kann.

Bei einer vorteilhaften Ausführungsform der Erfindung weist das Gehäuse einen Reflektor für die IR-Strahlung auf. Der Reflektor kann zur Strahlformung und/oder zur Strahllenkung der vom Silizium-Chip emittierten IR-Strahlung vorgesehen sein. Er kann beliebige geeignete Materialien aufweisen und eine der Anforderung genügende Geometrie. Er ist vorzugsweise als Plan- oder Hohlspiegel ausgebildet. Die Anordnung des Reflektors ist innen in oder außen an dem Gehäuse mit allen üblichen Befestigungsarten möglich. Ein außen vorgesehener Reflektor kann nachträglich auf die fertiggestellte Miniatur-Infrarotlichtquelle aufgesetzt werden, insbesondere vor oder nach der SMD-Montage. Ist der Reflektor im Gehäuse der Miniatur-Infrarotlichtquelle vorgesehen, so braucht die Austrittsöffnung und/oder das Austrittfenster nicht zwingend der Bodenplatte mit dem Silizium-Chip gegenüber zu liegen. Sie kann auch an einer Seitenwand des Gehäuses vorgesehen sein.

Abhängig von der Größe des Gehäuses und des Silizium-Chips können gegebenenfalls mehrere Silizium-Chips in ein einziges Gehäuse eingebaut und mit den Kontaktierungsstreifen zur Bestromung verbunden sein. Auch in einem solchen Fall ist eine hermetische Abdichtung der Austrittsöffnung des Gehäuses mittels einem Austrittsfenster, in oder ohne Kombination mit einem oder mehreren Filtern und/oder Reflektoren wie bei der Standardausführung mit nur einem Silizium-Chip vorgesehen, nicht ausgeschlossen.

Generell kann das Gehäuse, wenn es im Wesentlichen quaderförmig mit unterschiedlich großen Seitenflächen ausgebildet ist, mit allen Seitenflächen, ausgenommen der der Bodenplatte gegenüber liegenden Seitenfläche, in Richtung der Leiterplatte angeordnet werden, wenn die Kontaktierungsstreifen und gegebenenfalls das die Wärmesenke bildende Anschlusselement in geeigneter Weise aus dem Gehäuse heraus geführt sind. Die der Leiterplatte zugeordnete Seitenfläche des Gehäuses dient dabei als Befestigungsseite, als Bestückungsseite oder als Lötseite des Gehäuses. Für eine liegende Montage, bei der sich der Silizium-Chip in dem Gehäuse parallel zur Leiterplatte erstreckt, ist als Befestigungs-, Bestückungs- bzw. Lötseite die Bodenplatte, die vorzugsweise eine Flachseite bildet, vorgesehen und bei stehender Montage, bei der sich der Silizium-Chip in dem Gehäuse senkrecht zu der Leiterplatte erstreckt, eine Seitenwand des Gehäuses, die geneigt an die Bodenplatte anschließt.

Die erfindungsgemäße Detektoranordnung für einen Gassensor weist eine Miniatur-Infrarotlichtquelle wie vorstehend beschrieben und einen daran angepassten Infrarotdetektor auf. Dabei können die Miniatur-Infrarotlichtquelle und der Infrarotdetektor nebeneinander mit Abstand zueinander stehend und/oder liegend auf einer Schaltungsleiterplatte angeordnet sein, wobei sich bei liegender Anordnung die Austrittsöffnung bzw. das Austrittsfenster der Miniatur-Infrarotlichtquelle und eine Eintrittsöffnung bzw. ein Eintrittsfenster des Infrarotdetektors parallel zu der Leiterplatte und bei stehender Anordnung orthogonal zur Schaltungsleiterplatte erstreckt. Bei liegender Anordnung der Miniatur-Infrarotlichtquelle und/oder des Infrarotdetektors ist der liegenden Miniatur-Infrarotlichtquelle bzw. dem liegenden Infrarotdetektor jeweils ein Umlenkspiegel für die IR-Strahlung gegenüber liegend angeordnet, der die Infrarotstrahlung um 90° umlenkt.

Prinzipiell können die Miniatur-Infrarotlichtquelle der zugeordnete Infrarotdetektor auch in einem gemeinsamen Gehäuse untergebracht sein. Der Silizium-Chip der Infrarotlichtquelle und ein Sensor des Infrarotdetektors sind dabei günstigerweise nebeneinander mit seitlichem Abstand zueinander auf der Bodenplatte des Gehäuses angeordnet. Sie können getrennte Öffnungen oder Fenster für den Austritt bzw. Eintritt der IR-Strahlung aufweisen oder eine Öffnung oder ein Fenster gemeinsam nutzen. Für die Strahllenkung und/oder Strahlformung ist dem Gehäuse mit der Infrarotlichtquelle und dem Infrarotdetektor gegenüber liegend eine Spiegelanordnung zum Zurückwerfen der IR-Strahlung zu dem Gehäuse vorgesehen. Der mindestens eine Spiegel der Spiegelanordnung kann eine ebene, eine geknickte oder gekrümmte Reflektionsfläche aufweisen. Bei mehr als einem für die Siegelanordnung verwendeten Spiegeln können diese direkt nebeneinander oder entfernt voneinander angeordnet sein.

Nachfolgend wird die Erfindung anhand mehrerer in der Zeichnung dargestellter Ausführungsbeispiele näher erläutert. Weitere Merkmale der Erfindung ergeben sich aus der folgenden Beschreibung der Ausführungsbeispiele der Erfindung in Verbindung mit den Ansprüchen und der beigefügten Zeichnung. Die einzelnen Merkmale der Erfindung können für sich allein oder zu mehreren bei unterschiedlichen Ausführungsformen der Erfindung verwirklicht sein. Es zeigen:
- Figur 1: eine erste Ausführungsform der erfindungsgemäßen Miniatur- Infrarotlichtquelle für liegende Bestückung in einer Schnitt- darstellung, montiert auf einer Leiterplatte;
- Figur 2: eine zweite Ausführungsform der erfindungsgemäßen Miniatur- Infrarotlichtquelle für liegende Bestückung mit einer Wärmesenke in einer Schnittdarstellung, montiert auf einer Leiterplatte;
- Figur 3: die Miniatur-Infrarotlichtquelle aus Figur 1 mit einem aufgesetzten Reflektor in einer Schnittdarstellung;
- Figur 4: die Miniatur Infrarotüchtquelle aus Figur 1 mit einem Austritts- fenster das direkt auf dem Gehäuse angeordnet ist (Figur 4a), und mit einem auf dem Austrittsfenster aufgesetzten Reflektor (Figur 4b) sowie die Miniatur-Infrarotlichtquelle aus Figur 3 mit einem auf den Reflektor aufgesetzten Austrittsfenster (Figur 4c);
- Figur 5: eine dritte Ausführungsform der erfindungsgemäßen Miniatur- Infrarotlichtquelle für stehende Bestückung in einer Schnitt- darstellung, montiert auf einer Leiterplatte;
- Figur 6: drei Detektoranordnungen für einen Gassensor, mit einer erfindungsgemäßen Miniatur-Infrarotlichtquelle und einem Infrarotdetektor in getrennten Gehäusen, mit jeweils stehender Anordnung (Figur 6a), jeweils liegender Anordnung (Figur 6b) und mit unterschiedlicher Anordnung (Figur 6c); und
- Figur 7: eine Detektoranordnung für einen Gassensor, bei der die erfindungsgemäße Miniatur-Infrarotlichtquelle und der zuge- ordnete Infrarotdetektor in liegender Anordnung in einem gemeinsamen Gehäuse untergebracht sind.

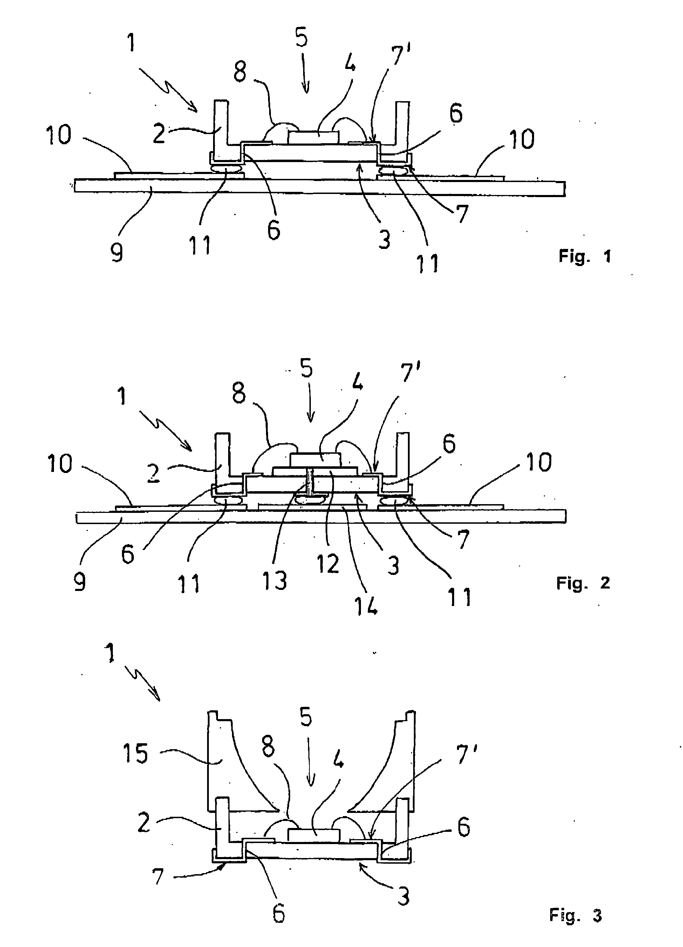

Figur 1 zeigt eine erfindungsgemäße Miniatur-Infrarotlichtquelle 1 hoher Leistung für einen Gassensor, mit einem Hitze beständigen Licht undurchlässigen Gehäuse 2, das eine Bodenplatte 3 mit einem aufgeklebten Silizium-Chip 4 in Membrantechnik aufweist. Der Bodenplatte 3 und dem Silizium-Chip 4 gegenüber liegend angeordnet ist eine Austrittsöffnung 5 des Gehäuses 2, aus der vom Silizium-Chip 4 beim Erhitzen auf typisch 400 bis 600 °C emittierte IR-Strahlung austreten kann. In das Gehäuse 2 führen zwei elektrische Anschlussleitungen 6 in Form von als Stanzblegeteile ausgeführten Kontaktierungsstreifen 6, die in das isolierende Material des Gehäuses 2 eingebettet sind. Die Kontaktierungsstreifen 6 sind mehrfach abgewinkelt ausgebildet und weisen parallel zu der Bodenplatte 3 verlaufende Anschlussabschnitte 7, 7' auf, die auf unterschiedlichen Seiten der Bodenplatte 3 angeordnet sind. Der Silizium-Chip 4 ist mit den sich im Innern des Gehäuses erstreckenden Anschlussabschnitten 7' Kontaktierungsstreifen 6 über Bonddrähte 8 verbunden. Die als Oberflächen montierbares Bauelement ausgebildete Miniatur-Infrarotlichtquelle 1 ist auf einer Schaltungsleiterplatte 9 montiert und mit den außen an dem Gehäuse 2 verlaufenden Anschlussabschnitten 7 der Kontaktierungsstreifen 6 mit Leiterbahnen 10 der Schaltungsleiterplatte 9 mittels einem Lötzinndepot 11 elektrisch leitend verbunden.

In Figur 2 ist eine wärmetechnisch verbesserte Ausführungsform der in Figur 1 abgebildeten erfindungsgemäßen Miniatur-Infrarotlichtquelle 1 dargestellt. Der Silizium-Chip 4 ist auf eine Wärmesenke 12 aufgeklebt, die an der Bodenplatte 3 des Gehäuses 2 angeordnet ist. Die Wärmesenke 12 ist von einem Anschlusselement 13 gebildet, das ähnlich den Kontaktierungsstreifen 6 ausgebildet ist. Das Anschlusselement 13 ist im Gehäuse 2 gut Wärme leitend mit dem Silizium-Chip 4 und außerhalb des Gehäuses mit einer Blindleiterbahn 14 der Schaltungsleiterplatte 9 mittels einem weiteren Lötzinndepot 11 verbunden. Damit bildet das Anschlusselement 13 eine Blindleitung 13 zu dem Silizium-Chip 4.

In der Figur 3 ist die Miniatur-Infrarotlichtquelle 1 aus Figur 1 ohne Leiterplatte jedoch mit aufgesetztem Reflektor 15 abgebildet, wobei der Reflektor 15 mit einer zentralen Durchtrittsöffnung für die IR-Strahlung ausgebildet ist. Der Reflektor 15 ist mit dem Gehäuse 2 fest verbunden und weist eine Strahl formende und Strahl lenkende Querschnittsform auf.

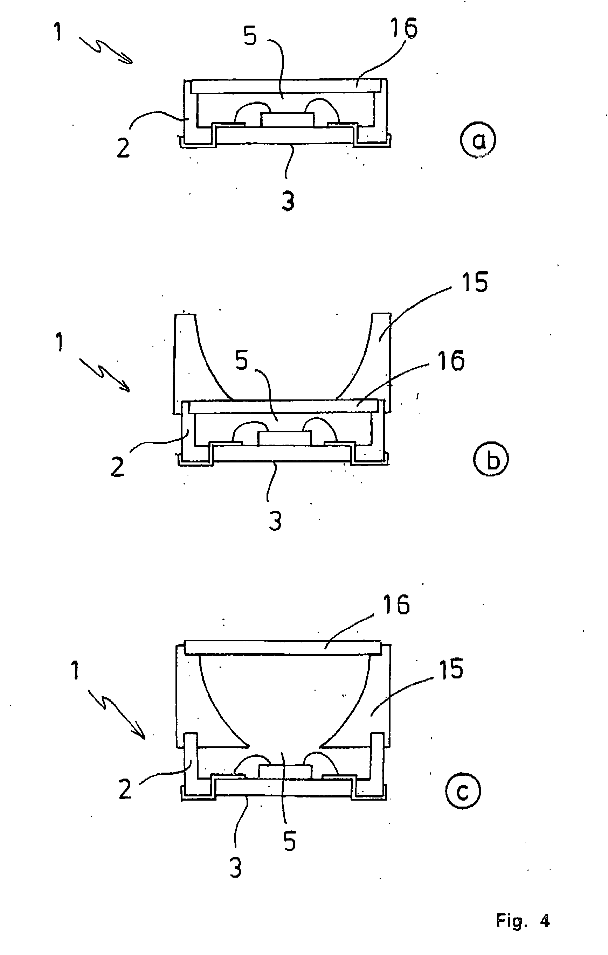

Die Figur 4 zeigt in den Figuren 4a, 4b, 4c die in den Figuren 1, 3 dargestellte Miniatur-Infrarotlichtquelle 1 mit einem hermetisch abdichtenden Austrittsfenster 16 für die von dem Silizium-Chip 4 ausgehende IR-Strahlung. Bei dem in der Figur 4a abgebildeten Ausführungsbeispiel ist das Austrittsfenster 16, das auch Filtereigenschaften aufweisen kann, direkt auf das Gehäuse 2 aufgesetzt. Die Figur 4b zeigt die Ausführungsform gemäß Figur 4a mit einem das Austrittsfenster 16 teilweise übergreifenden Reflektor 15, der in der Form entsprechend dem Reflektor 15 aus Figur 3 ausgeführt ist. Bei dem in der Figur 4c gezeigten Ausführungsbeispiel ist das Austrittsfenster 16 auf den Reflektor 15 der Anordnung gemäß Figur 3 außen aufgesetzt. Dabei dichtet das Austrittsfenster 16 zu dem Reflektor 15 hin und der Reflektor 15 zu dem Gehäuse 2 der Miniatur-Infrarotlichtquelle 1 hin ab.

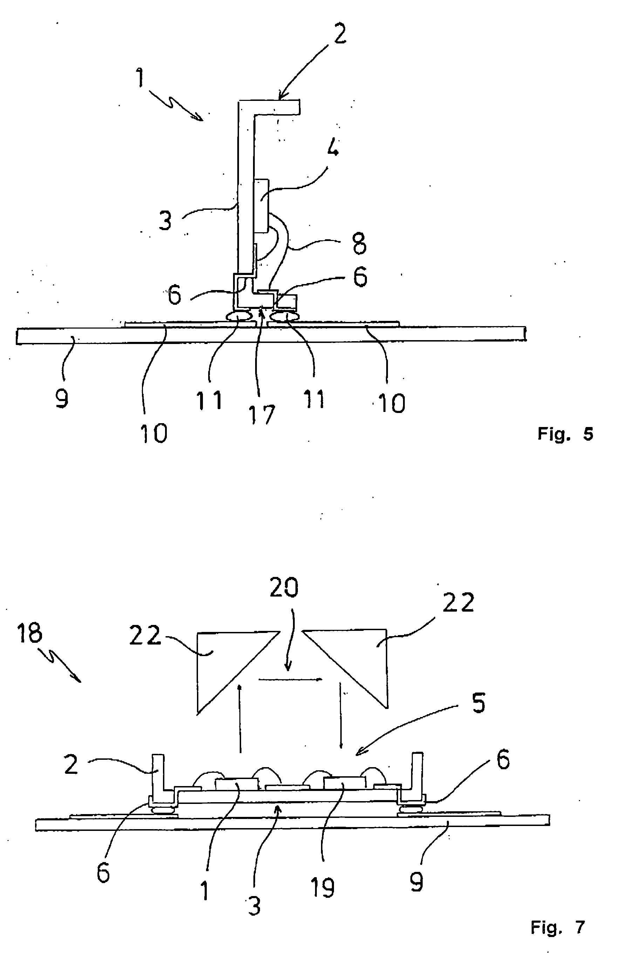

In der Figur 5 ist ein weiteres Ausführungsbeispiel der erfindungsgemäßen Miniatur-Infrarotlichtquelle 1 dargestellt. Das Gehäuse 2 der Miniatur-Infrarotlichtquelle 1 ist für eine stehende Montage auf der Schaltungsleiterplatte 9 vorgesehen. Dem entsprechend sind die die Anschlussleitungen 6 bildenden Kontaktierungsstreifen 6 auf einer Schmalseite 17 des Gehäuses 2, die sich quer zu der Bodenplatte 3 des Gehäuses 2 erstreckt, angeordnet. Die Kontaktierungsstreifen 6 verbinden den Silizium-Chip 4 in ähnlicher Weise mit der Schaltungsleiterplatte 9 wie bei dem in der Figur 1 dargestellten Ausführungsbeispiel.

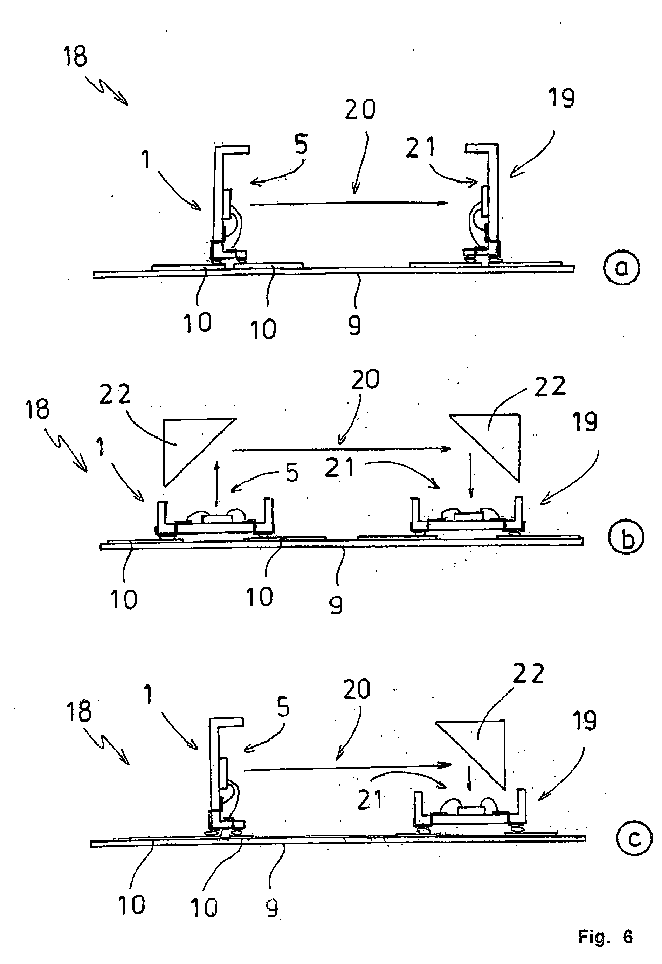

Die Figur 6 zeigt in den Figuren 6a, 6b, 6c verschiedene Detektoranordnungen 18 für einen in der Zeichnung nicht dargestellten Gassensor. Die Detektoranordnungen 18 weisen jeweils eine erfindungsgemäße Miniatur-Infrarotlichtquelle 1 sowie einen daran angepassten Infrarotdetektor 19 auf, die nebeneinander mit Abstand zueinander stehend und/oder liegend auf einer Schaltungsleiterplatte 9 angeordnet sind. Zwischen der Miniatur-Infrarotlichtquelle 1 und dem Infrarotdetektor 19 ist eine Infrarotabsorptionsstrecke 20 vorgesehen, in der sich die IR-Strahlung von der Miniatur-Infrarotlichtquelle 1 zu dem Infrarotdetektor 19 ausbreitet und bei Vorhandensein eines zu detektierenden Gases von dem Gas absorbiert wird.

Die Figur 6a zeigt eine erste Detektoranordnung 18, bei der sowohl die Miniatur-Infrarotlichtquelle 1 und der Infrarotdetektor 19 derart stehend zueinander angeordnet sind, dass sich die Austrittsöffnung 5 der Miniatur-Infrarotlichtquelle 1 und eine Eintrittsöffnung 21 des Infrarotdetektors 19 direkt fluchtend gegenüber liegend. Die Figur 6b zeigt eine zweite Detektoranordnung 18, bei der die Miniatur-infrarotlichtquelle 1 und der Infrarotdetektor 19 liegend auf der Schaltungsleiterplatte 9 angeordnet sind, so dass notwendigerweise die von dem Silizium-Chip 4 der Miniatur-Infrarotlichtquelle 1 emittierte IR-Strahlung nach der Austrittsöffnung 5 mittels zweier Umlenkspiegel 22 jeweils um 90° umgelenkt werden muss, um die Eintrittsöffnung 21 des Infrarotdetektors 19 zu erreichen. Die Figur 6c zeigt eine dritte Detektoranordnung 18, bei der die Miniatur-Infrarotlichtquelle 1 stehend und der Infrarotdetektor 19 liegend auf der Schaltungsleiterplatte 9 angeordnet ist. Dem entsprechend wird nur vor dem Infrarotdetektor 19 ein Umlenkspiegel 22 benötigt, der die IR-Strahlung in Richtung der Eintrittsöffnung 21 des Infrarotdetektors 19 umlenkt.

Die Figur 7 zeigt eine weitere Detektoranordnung 18, bei der sowohl die Miniatur-Infrarotlichtquelle 1 und der Infrarotdetektor 19 in liegender Anordnung in einem gemeinsamen Gehäuse 2 angeordnet sind. Dabei sind die Miniatur-Infrarotlichtquelle 1 und der Infrarotdetektor 19 nebeneinander liegend mit der Bodenplatte 3 des Gehäuses 2 und mit den aus dem Gehäuse 2 heraus führenden Kontaktierungsstreifen 6 verbunden. Das Gehäuse 2 weist eine Öffnung 5 oder ein in der Figur 7 nicht dargestelltes Fenster 16 für den Austritt bzw. Eintritt der IR-Strahlung auf, das die Infrarotlichtquelle 1 und den Infrarotdetektor 19 überdeckt. Gegenüber der Öffnung 5 oder dem Fenster 16 des Gehäuses 2 sind zwei zueinander und zu der Bodenplatte 3 hin geneigte Umlenkspiegel 22 vorgesehen, die die von der Miniatur-Infrarotlichtquelle 1 ausgehende IR-Strahlung jeweils um 90° zu dem Infrarotdetektor 19 hin umlenken. Alternativ kann an die Stelle der beiden Umlenkspiegel 22 mit planen Reflektionsflächen auch ein als Hohlspiegel ausgebildeter Umlenkspiegel 22 treten.

## Patentansprüche

1. Miniatur-Infrarotlichtquelle (1), mit einem Hitze beständigen, Licht undurchlässigen oder Licht durchlässigen Gehäuse (2), das eine Bodenplatte (3) und der Bodenplatte (3) gegenüber liegend eine Austrittsöffnung (5) oder ein Austrittsfenster (16) für IR-Strahlung aufweist, die von einem in dem Gehäuse (2) an der Bodenplatte (3) angeordneten, mindestens eine dünne Siliziummembran aufweisenden Silizium-Chip (4) beim Durchleiten eines geeigneten Heizstroms ausgeht, wobei der Silizium-Chip (4) mittels voneinander isolierten, das Gehäuse (2) dichtend durchtretenden elektrischen Anschlussleitungen (6) bestrombar ist, **dadurch gekennzeichnet, dass** das Gehäuse (2) und die Anschlussleitungen (6) nach Art eines Oberflächen montierbaren Bauelements ausgebildet sind.

2. Miniatur-Infrarotlichtquelle nach Anspruch 1, **dadurch gekennzeichnet, dass** der Silizium-Chip (4) direkt auf der Bodenplatte (3) befestigt ist.

3. Miniatur-Infrarotlichtquelle nach Anspruch 1, **dadurch gekennzeichnet, dass** der Silizium-Chip (4) auf einer Wärmesenke (12) der Bodenplatte (3) angeordnet ist.

4. Miniatur-Infrarotlichtquelle nach einem der voran gegangenen Ansprüche, **dadurch gekennzeichnet, dass** das Gehäuse (2) elektrisch isolierend ausgeführt ist und die Anschlussleitungen (6) von Stanzbiegeteilen gebildet und in das Gehäuse (2) eingebettet sind.

5. Miniatur-Infrarotlichtquelle nach Anspruch 3 oder 4, **dadurch gekennzeichnet, dass** eine der Anschlussleitungen (6) oder eine Blindleitung (13) die Wärmesenke (12) bilden.

6. Miniatur-Infrarotlichtquelle nach einem der voran gegangenen Ansprüche, **dadurch gekennzeichnet, dass** das Gehäuse (2) einen Reflektor (15) für die IR-Strahlung aufweist.

7. Miniatur-Infrarotlichtquelle nach einem der voran gegangenen Ansprüche, **dadurch gekennzeichnet, dass** als Bestückungsseite bzw. als Lötseite eine an die Bodenplatte (3) geneigt anschließende Seitenwand (17) des Gehäuses (2) vorgesehen ist.

8. Miniatur-Infrarotlichtquelle nach einem der voran gegangenen Ansprüche, **dadurch gekennzeichnet, das** die Miniatur-Infrarotlichtquelle (1) eine Lichtquelle hoher Leistung vorzugsweise für einen Gassensor ist.

9. Detektoranordnung (18) für einen Gassensor, mit einer Miniatur-Infrarotlichtquelle (1) und einem Infrarotdetektor (19), **gekennzeichnet durch** eine Miniatur-Infrarotlichtquelle (1) nach einem der voran gegangenen Ansprüche.

10. Detektoranordnung nach Anspruch 9, **dadurch gekennzeichnet, dass** die Miniatur-Infrarotlichtquelle (1) und der Infrarotdetektor (19) nebeneinander mit Abstand zueinander stehend und/oder liegend auf einer Schaltungsleiterplatte (9) angeordnet sind, wobei sich bei liegender Anordnung die Austrittsöffnung (5) bzw. das Austrittsfenster (16) der Miniatur-Infrarotlichtquelle (1) und eine Eintrittsöffnung (21) bzw. ein Eintrittsfenster (21) des Infrarotdetektors (19) parallel und bei stehender Anordnung orthogonal zur Schaltungsleiterplatte (9) erstreckt, und wobei der liegenden Miniatur-Infrarotlichtquelle (1) und/oder dem liegenden Infrarotdetektor (19) ein planer oder gekrümmter Umlenkspiegel (22) für die IR-Strahlung gegenüber liegt.

11. Detektoranordnung nach Anspruch 10, **dadurch gekennzeichnet, dass** die Miniatur-Infrarotlichtquelle (1) und der Infrarotdetektar (19) ein gemeinsames Gehäuse (2) aufweisen.
